# EUROPEAN PATENT APPLICATION

(11) **EP 3 719 473 A2**
(43) Date of publication of application: **07.10.2020**
(21) Application number: 20167988.3
(22) Date of filing: 03.04.2020
(51) Int. Cl.: G01M 3/28, G01M 3/38, F17D 5/00

(54) **MULTI-UTILITY INTEGRITY MONITORING AND DISPLAY SYSTEM**

(30) Priority: 05.04.2019 US 201962830050 P; 02.04.2020 US 202016839037
(71) Applicant: ID Technologies Inc., Calgary, AB T2H 2Z9 (CA)
(72) Inventor: Agouridis, Dimitris, Calgary, Alberta AB T2H 2Z9 (CA); Mufti, Muid, Calgary, Alberta AB T2H 2Z9 (CA)
(74) Representative: Betten & Resch

(57) **Abstract**

Numerous embodiments are disclosed for monitoring multiple utility networks and structures, such as gas pipes, water pipes, electricity networks, traffic lights, street lights, sewers, and other utilities. Local sensors detect leaks, short-circuits, and other incidents. Data from the local sensors are collected by data collection units and sent to a server over a fiber optic or wireless connection. The server optionally can superimpose depictions of the incidents over a map, blueprint, photograph, or live image using a geographic information system (GIS) or augmented reality application.

## Description

### PRIORITY CLAIM

This application claims priority to United States Patent Application No. 62/830,050, filed on April 5, 2019, and titled, "Multiutility Integrity System," which is incorporated by reference herein.

### FIELD OF THE INVENTION

Numerous embodiments are disclosed for monitoring multiple utility networks and structures, such as gas pipes, water pipes, electricity networks, traffic lights, street lights, sewers, and other utilities. Local sensors detect leaks, short-circuits, and other incidents. Data from the local sensors are collected by data collection units and sent to a server over a fiber optic or wireless connection. The server optionally can superimpose depictions of the incidents over a map, blueprint, photograph, or live image using a geographic information system (GIS) or augmented reality application.

### BACKGROUND OF THE INVENTION

Managing and maintaining utility systems is a herculean task. Gas pipes, water pipes, electricity networks, sewers, and other utilities can span hundreds of miles within dense cities and into the rural countryside. Any number of incidents can occur at any time to cause leaks and other problems with the utilities. For example, in recent times, short-circuits within electric towers carrying high voltage power lines have caused rampant forest fires, resulting in billions of dollars in damage to businesses and residential communities.

The prior art does not include an automated mechanism for identifying incidents within a utility network, generating an alert in response to the incident, and generating a visual identification of the exact location within the utility network where the incident occurred. The prior art also does not include the ability to using data analytics to analyze incidents or to predict where future incidents will occur.

What is needed is a smart utility monitoring system comprising sensors that detect incidents and communicate information about those incidents over a network to a server. What is further needed is the ability to superimpose depictions of such incidents on a map, photograph, or blueprint within a GIS. What is further needed is a data analytics module can analyze incidents and predict where future incidents will occur.

### SUMMARY OF THE INVENTION

Numerous embodiments are disclosed for monitoring multiple utility networks and structures, such as gas pipes, water pipes, electricity networks, traffic lights, street lights, sewers, and other utilities. Local sensors detect leaks, short-circuits, and other incidents. Data from the local sensors are collected by data collection units and sent to a server over a fiber optic or wireless connection. The server optionally can superimpose depictions of the incidents over a map, blueprint, photograph, or live image using a GIS or augmented reality application.

### BRIEF DESCRIPTION OF THE DRAWINGS

Figure 1 depicts a multi-utility integrity monitoring system.
Figure 2 depicts hardware components of a computing device used in the multi-utility integrity monitoring system.
Figure 3 depicts software components of a client device used in the multi-utility integrity monitoring system.
Figure 4 depicts software components of a server used in the multi-utility integrity monitoring system
Figure 5 depicts a gas sensor sub-system used in the multi-utility integrity monitoring system.
Figure 6 depicts an electricity network sensor sub-system used in the multi-utility integrity monitoring system.
Figure 7 depicts an induction based leakage detector used in the electricity network sensor sub-system.
Figure 8A depicts a GIS map view.
Figure 8B depicts a GIS blueprint view.
Figure 8C depicts a GIS photograph view
Figure 9 depicts a GIS map view.
Figure 10 depicts a GIS photograph alert view.
Figure 11 depicts a GIS map alert view.
Figure 12 depicts a GIS photograph alert view.
Figure 13 depicts a GIS photograph alert view.
Figure 14 depicts an exemplary log-in page generated by a server.
Figure 15 depicts another GIS map view.
Figure 16 depicts an exemplary cost report.
Figure 17 depicts an exemplary data analytics report.
Figure 18 depicts an exemplary data analytics report.
Figure 19 depicts an exemplary data analytics report.

### DETAILED DESCRIPTION OF THE INVENTION

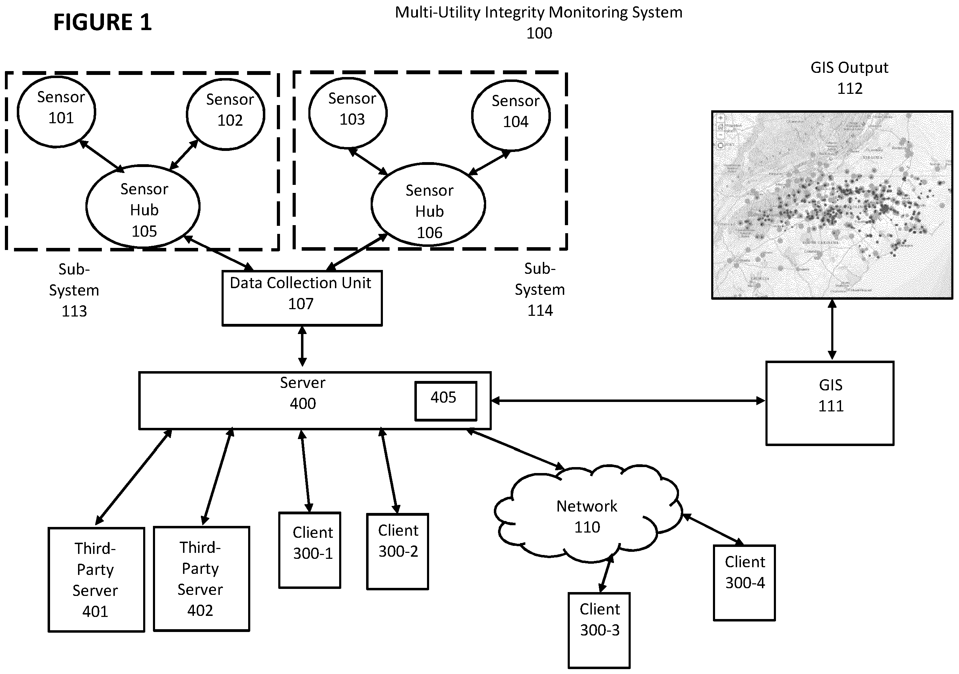

Figure 1 depicts multi-utility integrity monitoring system 100. Multi-utility integrity monitoring system 100 comprises server 400, which the applicant refers to as "PHOSPHOROUS," and which performs many of the functions described below. Server 400 comprises reporting module 405, which applicant refers to as "BOSS" (Business Objectives Support System) and which performs a data analytics and reporting function. Optionally, server 400 can comprise a single hardware server or it can include a plurality of hardware servers.

Multi-utility integrity monitoring system 100 further comprises sensors 101, 102, 103, and 104; sensor hubs 105 and 106; data collection unit 107; third-party servers 401 and 401; clients 300-1, 300-2, 300-3, and 300-4; network 110; GIS 111; and GIS output 112. One of ordinary skill in the art will appreciate that the components depicted in Figure 1 are exemplary and that many other instances of each type of component can be present. For example, for a municipal utility system, hundreds of sensors and sensor hubs may be used. GIS 111 can be a stand-alone computing device, or it can be executed within server 400 itself.

A wired link or network (such as a fiber optic connection, Ethernet network, etc.) or a wireless link or network (such as a 3G, 4G, or 5G cellular connection, an 802.11 connection, etc.) is used between: sensors 101 and 102 and sensor hub 105; sensors 103 and 104 and sensor hub 106; sensor hubs 105 and 106 and data collection unit 107; data collection unit 107 and server 400; third-party servers 401 and 402 and server 400; clients 300-1 and 300-2 and server 400; server 400 and network 110; clients 300-3 and 300-4 and network 110; and server 400 and GIS 111. Network 110 can be a local area network (LAN), wide area network (WAN), the Internet, or other type of network.

Third-party servers 401 and 402 can be third-party servers running online monitoring software. Optionally, third-party servers 401 and 401 can communicate with server 400 using application programming interfaces (APIs).

In the particular example shown in Figure 1, sensors 101 and 102 and sensor hub 105 form sub-system 113, and sensors 103 and 104 and sensor hub 106 form sub-system 114. Each of sub-systems 113 and 114 detect a particular type of incident for a particular type of utility. For example, sensors 101 and 102 can be pressure measurement devices for a gas pipeline, and sensors 103 and 104 can be ground current detection devices for an electric tower within an electricity network. Using sub-systems such as sub-systems 113 and 114, multi-utility integrity monitoring system can detect numerous incidents that might occur within a utility network, such as explosions, leaks, machinery-caused defects, plugs or ruptures caused by landslides, and issues due to extreme temperatures, vibrations or noise.

Server 400 can operate as an asset management and integrity system that ensures the proper functionality of all municipal networks and collects data from all network assets via specialized sensors 101, 102, 103, and 104, in structures such as gas networks, storm water systems, sewers, water, electric networks, telecommunications, transportation and any kind of hard infrastructure like storm water catch basins, water mains pressure valves, fire hydrants, poles, streetlights, traffic lights, traffic cameras, parking meters, etc. Sensors 101, 102, 103, and 104 can be proprietary sensors or off-the-self sensors (including SCADA). Server 400 collects data from these sensors, and reporting module 405 can generate numerics, perform decision analysis, and extract valuable quantitative and qualitative results regarding the functionality of the monitored networks and structures, in addition to providing recommendations and alerts of network overflow capacity, malfunctioning, and upgrading of the networks.

Server 400 also can incorporate additional information derived from various maintenance services such as CCTV video pipe inspections, cleanup and flushing, and sewer inspections, and can integrate this information with functionality data in order to ensure proper integrity of the monitored networks and components. Such integrity functionality is essential prerequisite during emergencies and natural disasters such as flooding and fires and in assisting all emergency responders in providing relief services. Server 400 monitors improper or insufficient functionality of the networks and provides information and generates alerts for repairs by creating automated emergency and regular work orders pertaining to maintenance and other types of asset-related work in order to prevent infrastructure failure and promote public safety.

For example, heavy rains can cause extensive flooding in urban residential areas, and there is a need to maintain full capacity water flow through storm water catch basins and to clean the storm system to ensure water flow without damaging the pipes. Ongoing monitoring via server 400 can establish allowable water flow pressure thresholds in storm waterpipes prior to rupture and generate alerts for emergency response services.

As another example, water leaks in water mains account for a high percentage of water usage/waste in all developing countries and in some developed countries. Such losses can reach extreme amounts of up to 60% of the total water usage and become a dramatic loss of vital resource and a burden for the citizens. Server 400 is able to monitor the flow at various points in the water network and relate it to consumed amounts of water recorded in billing systems accessible by serer 400. Server 400 can establish areas of leakage by data correlation and enable on-site underground inspections to localize the leaking sources.

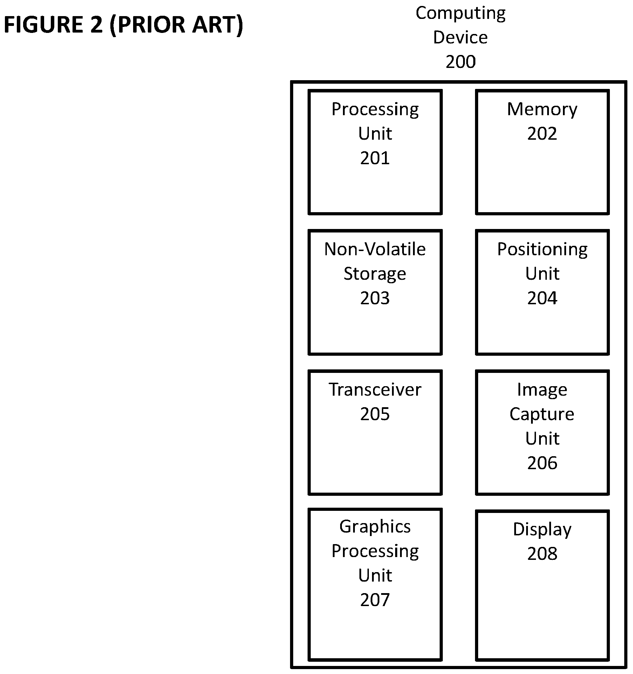

Figure 2 depicts hardware components of computing device 200, which can be used for any of sensor hubs 105, 106, data collection unit 107, server 400, third-party servers 401 and 402, clients 300-1, 300-2, 300-3, and 300-4, and GIS 111 in Figure 1. These hardware components are known in the prior art.

Computing device 200 comprises processing unit 201, memory 202, non-volatile storage 203, positioning unit 204, network interface 205, image capture unit 206, graphics processing unit 207, and display 208. Client device 200 can be a server, client, smartphone, notebook computer, tablet, desktop computer, gaming unit, wearable computing device such as a watch or glasses, or any other computing device.

Processing unit 201 optionally comprises a microprocessor with one or more processing cores. Memory 202 optionally comprises DRAM or SRAM volatile memory. Non-volatile storage 203 optionally comprises a hard disk drive or flash memory array. Positioning unit 204 optionally comprises a GPS unit or GNSS unit that communicates with GPS or GNSS satellites to determine latitude and longitude coordinates for client device 200, usually output as latitude data and longitude data. Network interface 205 optionally comprises a wired interface (e.g., Ethernet interface) or wireless interface (e.g., 3G, 4G, 5G, GSM, 802.11, protocol known by the trademark "BLUETOOTH," etc.). Image capture unit 206 optionally comprises one or more standard cameras (as is currently found on most smartphones, tablets, and notebook computers). Graphics processing unit 207 optionally comprises a controller or processor for generating graphics for display. Display 208 displays the graphics generated by graphics processing unit 207, and optionally comprises a monitor, touchscreen, or other type of display.

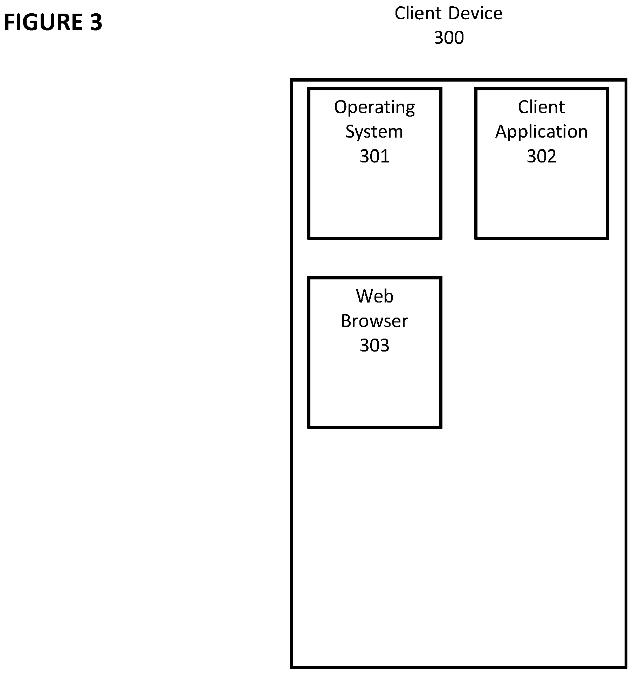

Figure 3 depicts software components that are installed in and operated by computing device 200 to form client device 300 (such as any of client devices 300-1, 300-2, 300-3, and 300-4 in Figure 1). Client device 300 comprises operating system 301 (such as the operating systems known by the trademarks "WINDOWS," "LINUX," "ANDROID," "IOS," or others), client application 302, and web browser 303.

Client application 302 comprises lines of software code executed by processing unit 201 to perform the functions described below. For example, client device 300 can be a smartphone or tablet sold with the trademark "GALAXY" by Samsung or "IPHONE" by Apple, and client application 302 can be a downloadable app installed on the smartphone or tablet. Client device 300 also can be a notebook computer, desktop computer, game system, or other computing device, and client application 302 can be a software application running on client device 300. Client application 302 forms an important component of the inventive aspect of the embodiments described herein, and client application 302 is not known in the prior art.

Web browser 303 comprises lines of software code executed by processing unit 201 to access web servers, display pages and content from web sites, and to provide functionality used in conjunction with web servers and web sites, such as the web browsers known by the trademarks "INTERNET EXPLORER," "CHROME," AND "SAFARI."

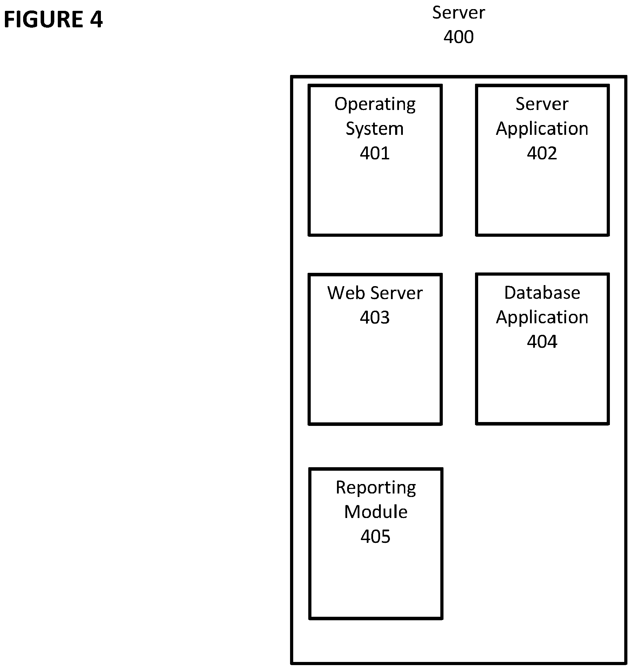

Figure 4 depicts software components that are installed in and operated by computing device 200 to form server 400.

Server 400 comprises operating system 401 (such as the operating systems known by the trademarks "WINDOWS," "LINUX, "ANDROID," "IOS," or others), server application 402, web server 403, database application 404, and reporting module 405.

Server application 402 comprises lines of software code executed by processing unit 201 to interact with client application 302 and to perform the functions described below. Server application 402 forms an important component of the inventive aspect of the embodiments described herein, and server application 402 is not known in the prior art.

Web server 403 is a web page generation program capable of interacting with web browser 303 on client device 300 to display web pages, such as the web server known by the trademark "APACHE."

Database application 404 comprises lines of software code executed by processing unit 401 to generate and maintain a database, such as an SQL database.

Reporting module 405 comprises lines of software code executed by processing unit 401 to perform data analytics and reporting functionality, such as analyzing network load, performing risk analysis for failure or rupture of components within the monitored networks and structures, analyzing network integrity and the failure of networks and structures, and calculating cost and other financial information.

GIS 111 can be a server 400 or a client device 300 running a GIS software application and having access to maps, photographs, and blueprints as discussed in greater detail below.

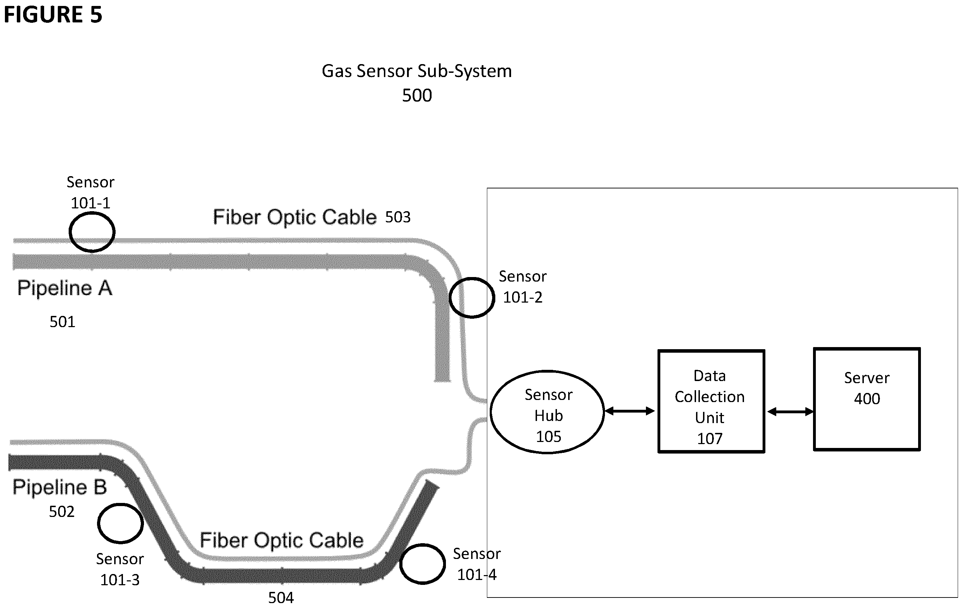

Figure 5 depicts gas sensor sub-system 500, which contains an exemplary set of sensors 101 and a sensor hub 105 for detecting gas leaks in gas pipelines 501 and 502. Gas sensor sub-system 500 is an example of sub-system 113 and 114 shown in Figure 1.

Fiber optic cable 503 runs alongside gas pipeline 501, and fiber optic cable 504 runs alongside gas pipeline 502. Periodically, a sensor is placed on gas pipelines 501 and 502 to measure pressure or throughout within the pipeline at that particular location, and the sensor transmits collected data to sensor hub 105. In this example, sensors 101-1 and 101-2 are placed on pipeline 501, and sensors 101-3 and 101-4 are placed on pipeline 502. Sensor hub 105 collects data from sensors 101-1, 101-2, 101-3, and 101-4 and provides the data to data collection unit 107, which in turn provides the data to server 400.

A leak in one of the pipelines can be identified if the data collected from one sensor is inconsistent with the data collected from another sensor. For example, if sensor 101-1 detects a pressure X within pipeline 501, and sensor 101-2 detects a pressure 0.8X, then server 400 can deduce that there is a leak in pipeline 501 between sensors 101-1 and 101-2, as the pressure should have been approximately the same between those two locations. Optionally, this deduction can be made if the difference between the two detected pressures is greater than a predetermined threshold.

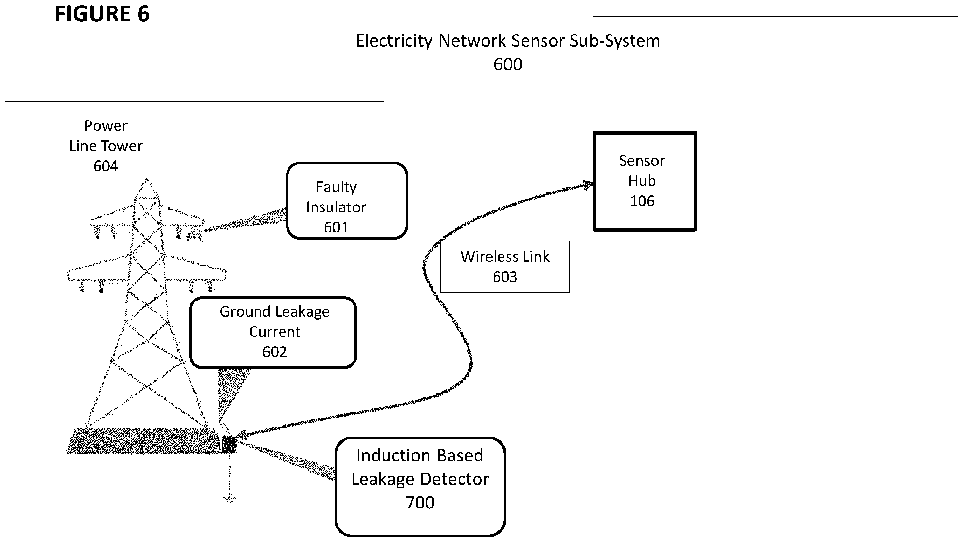

Figure 6 depicts electricity network sensor sub-system 600. Electricity network sensor sub-system 600 is an example of sub-system 113 and 114 in Figure 1.

Exemplary power line tower 604 is depicted. Power lines usually contain a high voltage such as 27.6 KV and are separated from the tower by insulators. When an insulator gets corroded or damaged, current can leak downwards in the pole to the ground. This can cause injuries to animals through electrocution or can cause vegetation to catch fire.

To detect such incidents, induction based leakage detector 700 is installed either between each inductor and the tower, or near the bottom of the tower. Induction based leakage detector 700 communicates with sensor hub 106 over wireless link 603. Here, faulty insulator 601 is present and causes ground leakage current 602 to run from the power line to ground through the tower (which typically is constructed of metal). Some or all of this current traverses through induction based leakage detector 700.

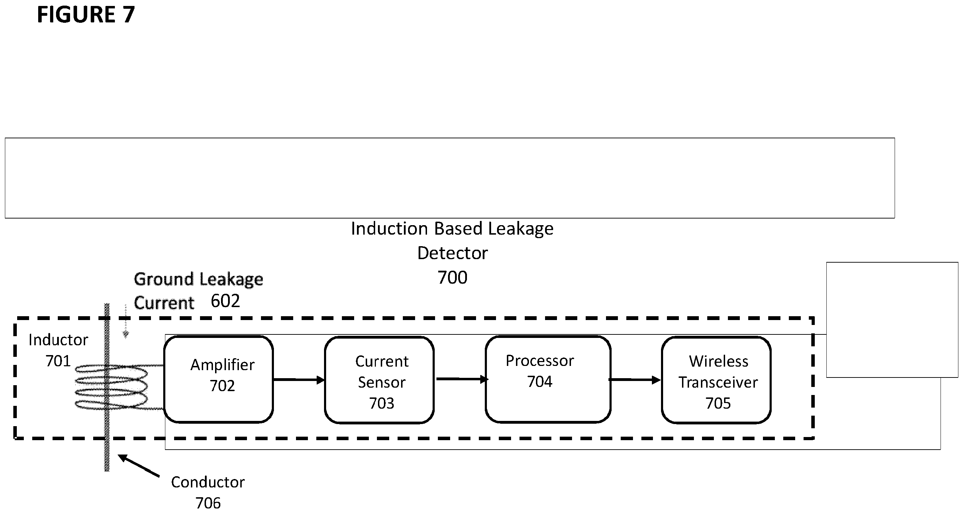

Figure 7 shows additional detail regarding induction based leakage detector 700, which comprises inductor 701, amplifier 702, current sensor 703, processor 704, and wireless transceiver 705. Inductor 701 is a metal coil that surrounds conductor 706 that is part of tower 604 or is connected between tower 604 and ground. Some or all of ground leakage current 602 will then travel through conductor 706 to ground, which will generate current in the coil due to inductive forces. That current will be sensed by amplifier 702, which will amplify it. Current sensor 703 then measures the amplified current output by amplifier 702 and provides a measurement in digital form to processor 704, which then communicates with server 400 over wireless transceiver, where processor 704 informs server 400 of the amount of amplified current sensed. If the amount of amplified current sensed is greater than 0 A, then server 400 will know there is leakage in tower 604, which will point to a faulty insulator such as faulty insulator 601 in Figure 6.

Induction based leakage detector 700 can be used in power line towers, streetlights, traffic lights, or any utility structure that carries electricity. Optionally, a maintenance crew member can carry client 300-1 with him or her, and when he or she approaches the structure containing ground leakage current 602, client 300-1 (based on communications from server 400) will issue an alert to inform the maintenance crew member that he or she is approaching the dangerous condition.

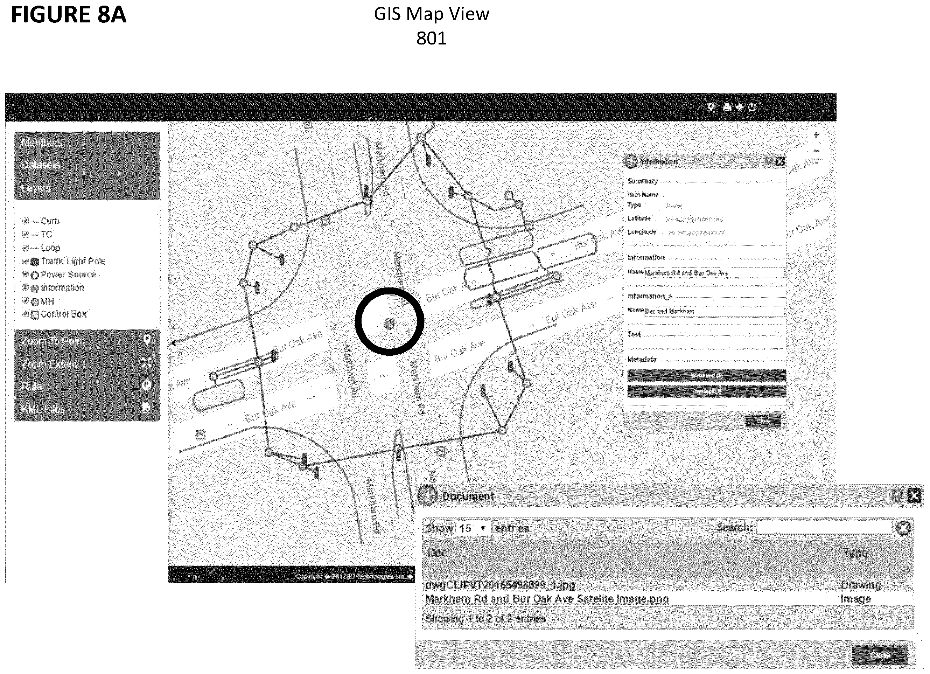

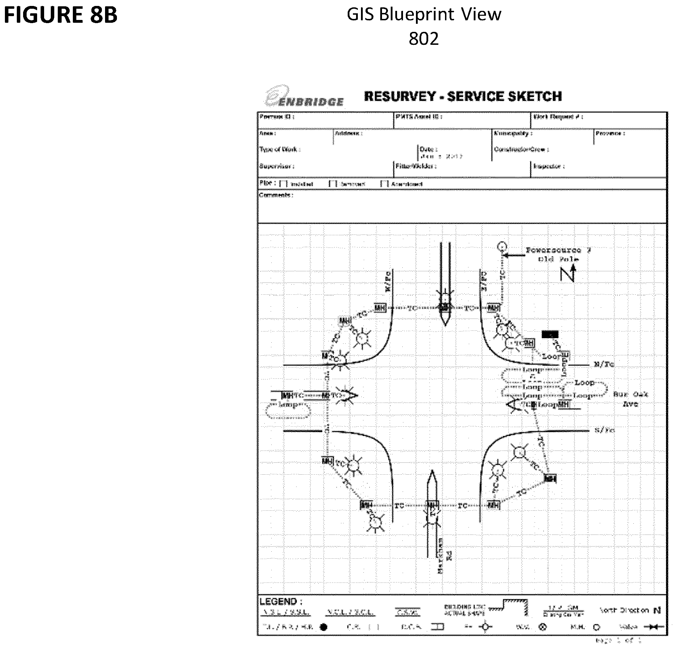

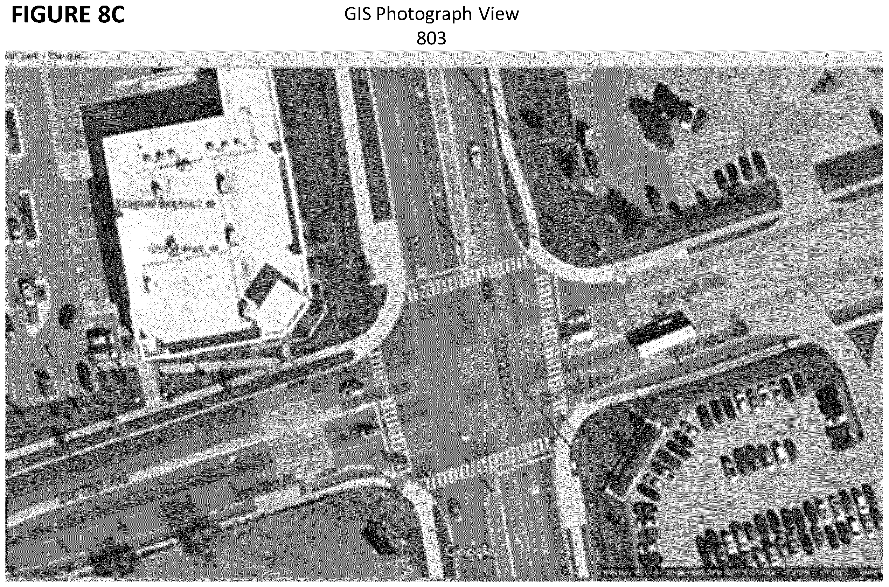

Figures 8A, 8B, and 8C depict another aspect of the embodiments that integrates the sensor data described previously with geolocation data typically used in GIS environments.

Figure 8A depicts GIS map view 801, which is an image generates by GIS 111 as GIS output 112 that shows the map of a particular intersection with superimposed markings depicting traffic lights, loops, wiring, and control boxes.

Figure 8B depicts GIS blueprint view 802, which is generated by GIS 111 as GIS output 112 that shows the original blueprint for the particular intersection with the original plans for the traffic lights, loops, wiring, and control boxes.

Figure 8C depicts GIS photograph view 803, which is generated by GIS 111 as GIS output 112 that shows a map (taken by a drone, satellite, or other means) with superimposed markings depicting traffic lights, loops, wiring, and control boxes.

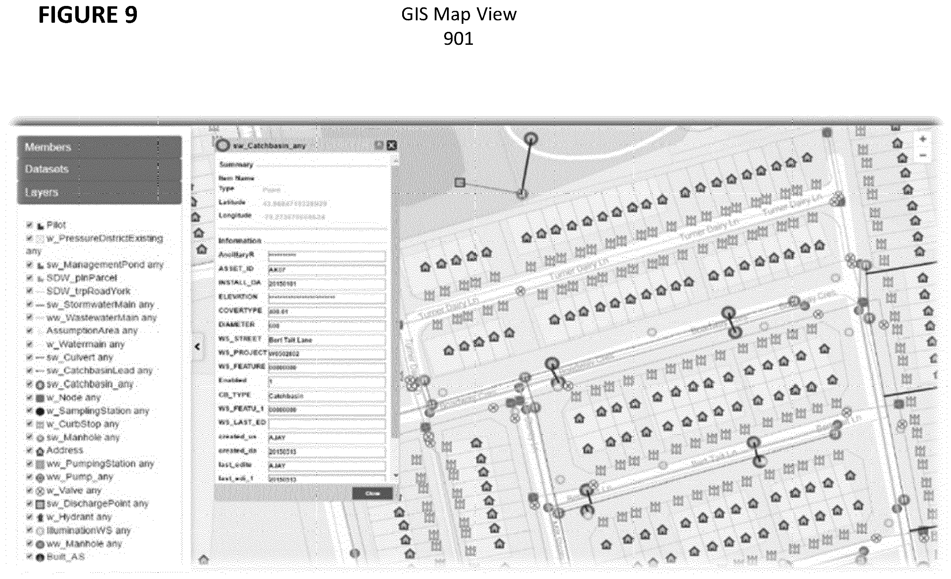

Figure 9 depicts GIS map view 901, which is generated by GIS 111 as GIS output 112, which shows a map of a particular neighborhood with superimposed markings showing streetlights.

Thus, Figures 8A, 8B, 8C, and 9 provide a powerful mechanism by which a municipal official can view a utility layout, in this example, traffic lights, street lights, and related infrastructure superimposed over a GIS geolocation image. The same can be performed for other utilities, such as gas pipelines, water pipelines, electric conduits, telephone lines, cable TV lines, sewer, etc.

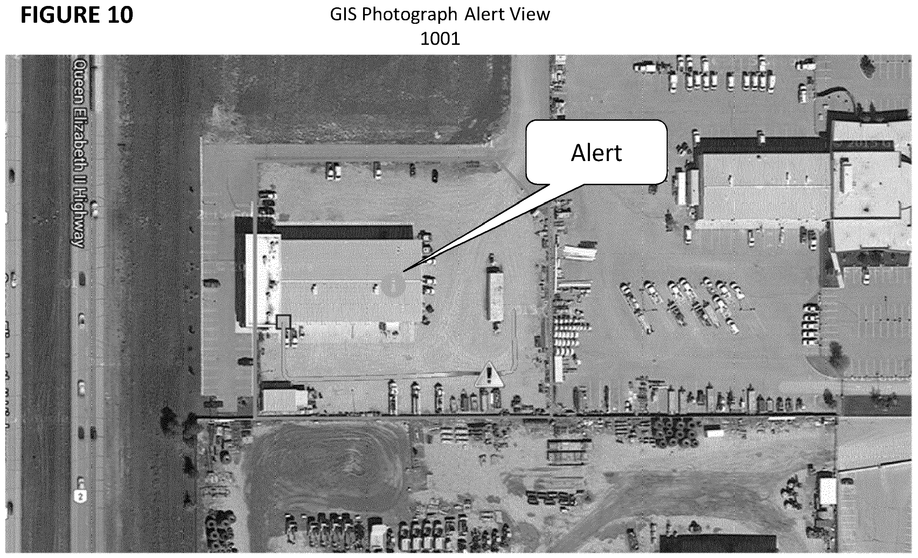

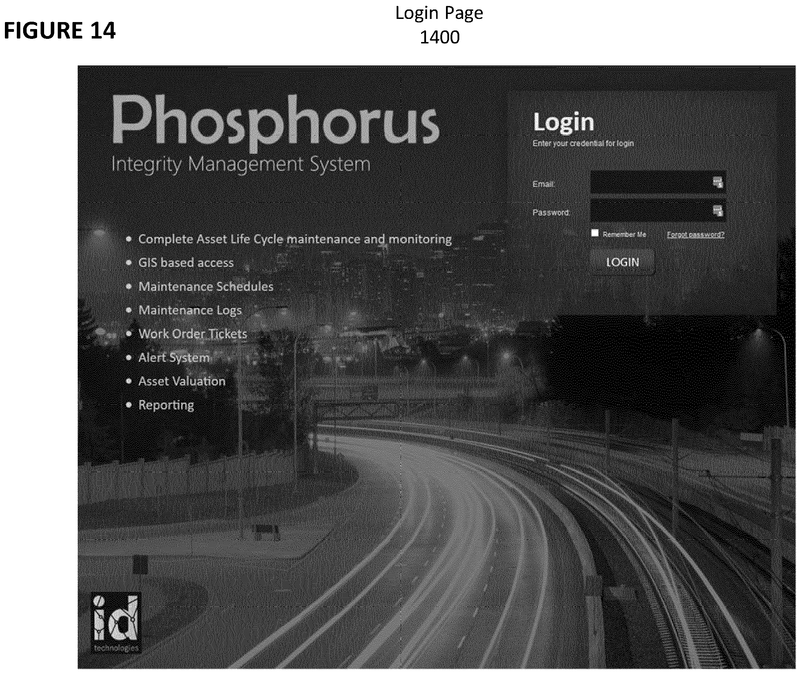

Figures 10-14 depict another aspect of the embodiments.

Figure 10 depicts GIS photograph alert view 1001, which is generated by GIS 111 as GIS output 112 and shows a photograph of a warehouse area with superimposed markings showing an alert. For example, if a sensor detects a gas leak, water leak, or electric short in this area, an alert can be generated and displayed for a municipal administrator. This also can provide an additional safety measure when an installation, such as installing a new gas appliance or hooking up a building's gas pipes to the main line, is performed. For example, if a leak occurs, server 400 will immediately learn of the leak and can issue alerts to the crew performing the installation.

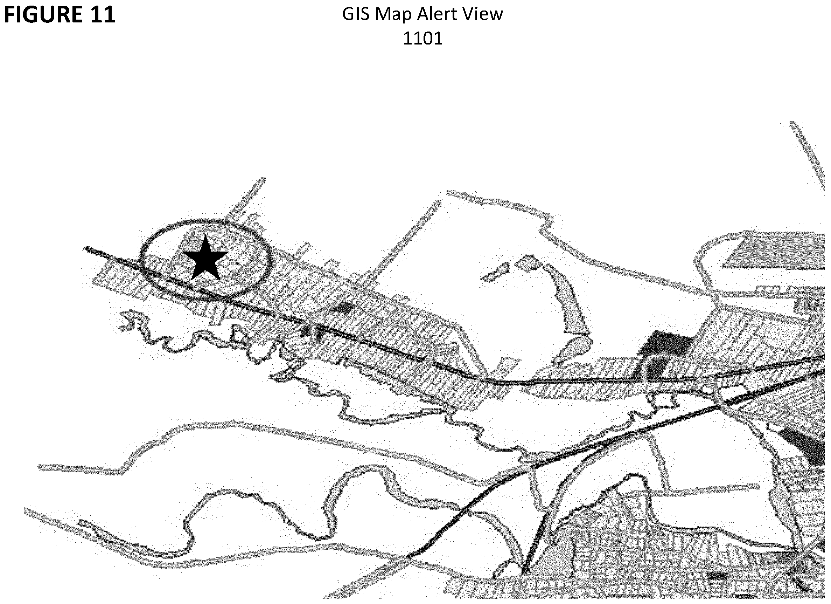

Figure 11 depicts GIS map alert view 1101, which is generated by GIS 111 as GIS output 112 that shows a map of a neighborhood with superimposed markings showing an alert. For example, if a sensor detects a gas leak, water leak, or electric short in this area, an alert can be generated and displayed for a municipal administrator.

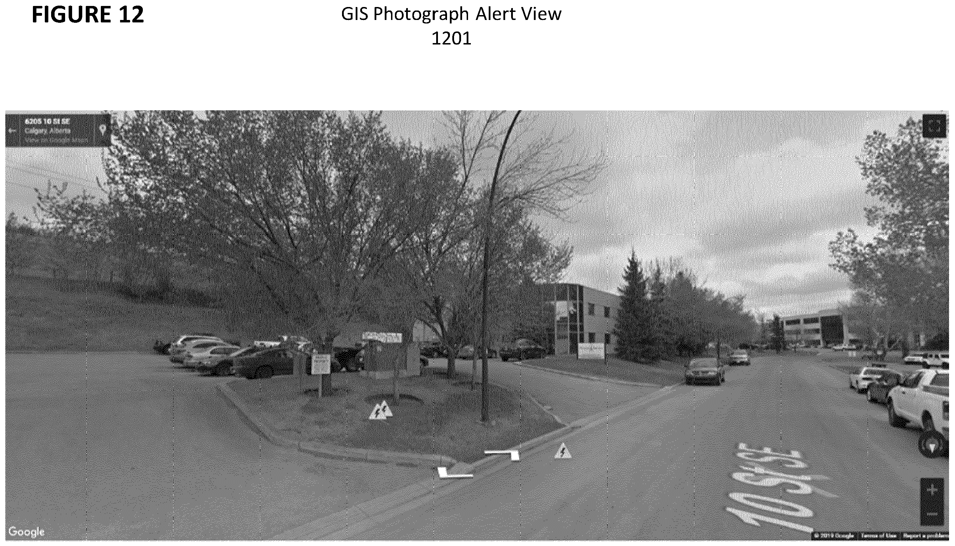

Figure 12 depicts GIS photograph alert view 1201, which is generated by GIS 111 as GIS output 112 that shows a photograph of a parking lot with a superimposed alert. For example, if a sensor detects a gas leak, water leak, or electric short in this area, an alert can be generated and displayed for a municipal administrator.

In the alternative, GIS photograph alert 1201 can be generated in an augmented reality application running on a client device, such as client device 300-1, where image capture unit 206 captures the photo and displays it on display 208 (as would be the case in viewing the area through a mobile phone's camera), and client application 302 superimposes the alert over the live-captured photo. This would be useful, for instance, for a city worker to be able to quickly find the leak that is causing the alert to be generated.

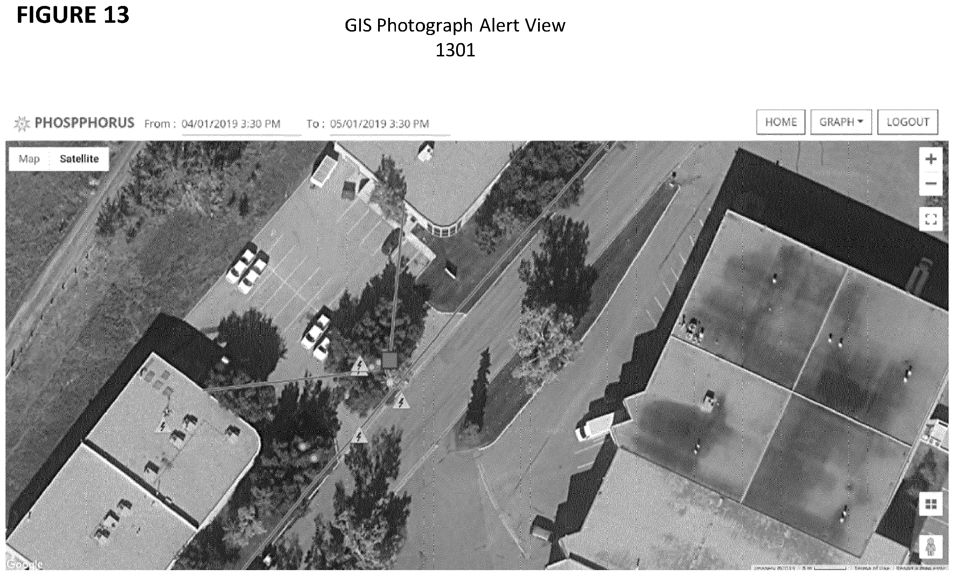

Figure 13 depicts GIS photograph alert view 1301, which is generated by GIS 111 as GIS output 112 and that shows a photograph of the same parking lot from Figure 12 with a superimposed alert as well as markings depicting gas lines, water lines, or electric lines. This would be useful, for instance, for a city worker to be able to quickly find the leak that is generating the alert and to understand where the underlying pipes are located.

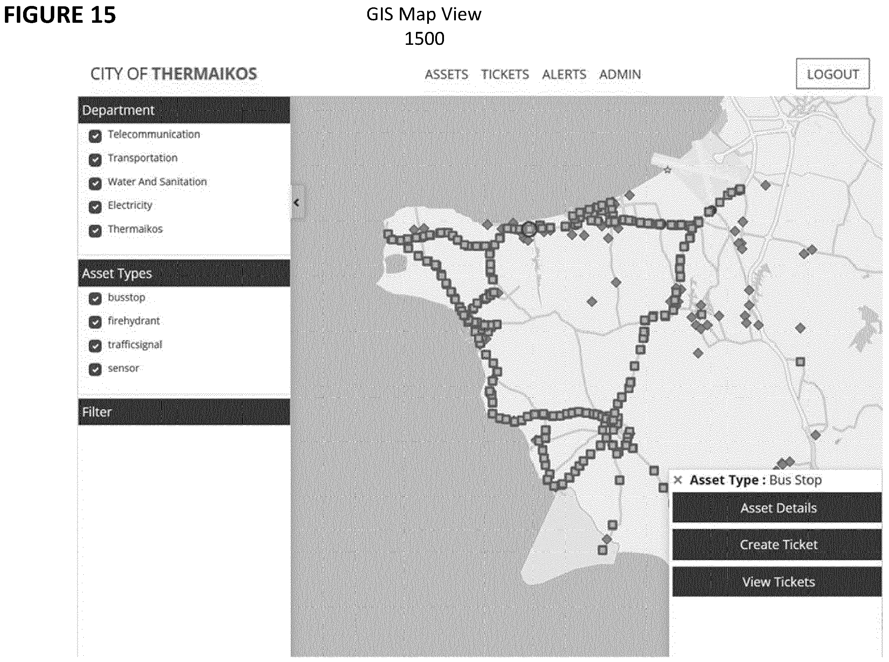

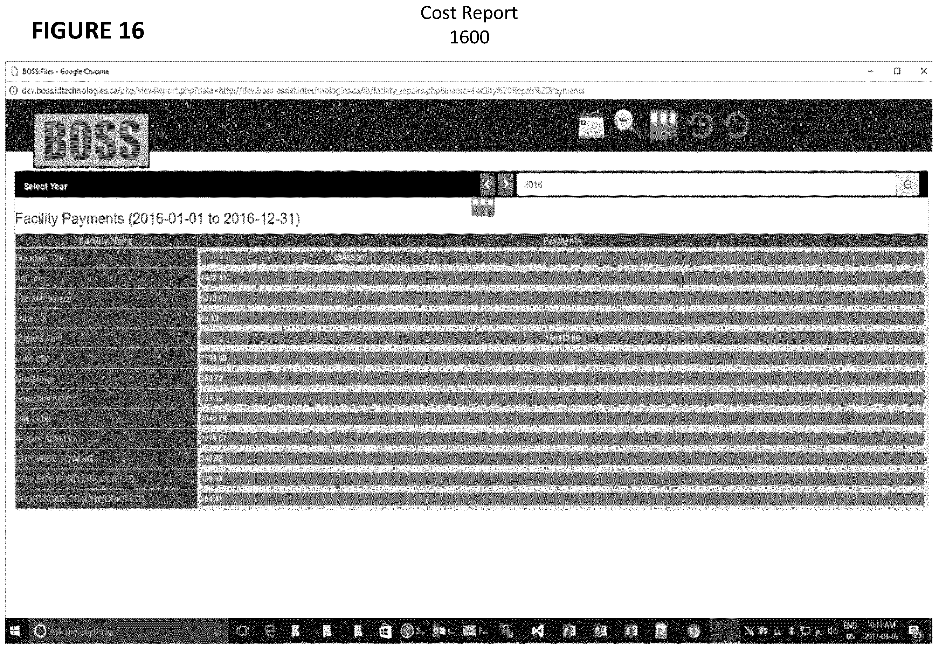

Figure 15 depicts exemplary login page 1400, which web server 403 within server 400 can generate to allow users to log on to server 400 from a client 300. Figure 16 depicts an exemplary home screen for a particular user upon login, which here is GIS map view 1600, which shows a map of the area of interest along with the location of all monitored systems and structures.

Optionally, reporting module 405 collects information gathered and generated by server 400 and shares that information with stake holders on subscription basis. Reports generated by reporting module 405 can be accessed as follows: (1) on-demand from a portal operated by server 300; (2) through cyclic displays for a passive audience; and (3) on subscription through email. Subscriptions can be send on a periodic basis, such as yearly, monthly, or daily.

Figure 16 depicts an exemplary cost report generated by reporting module 405.

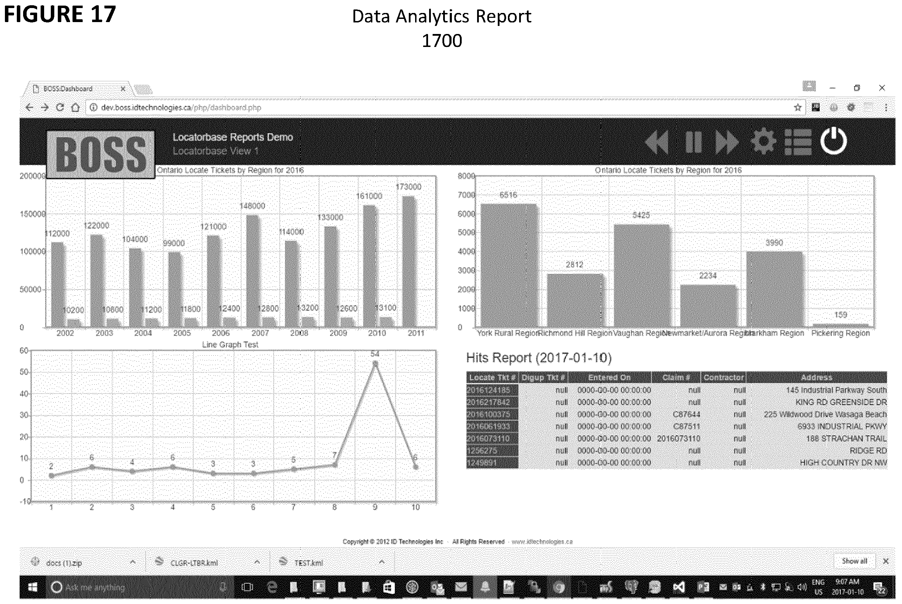

Figure 17 depicts an exemplary data analytics report generated by reporting module 405.

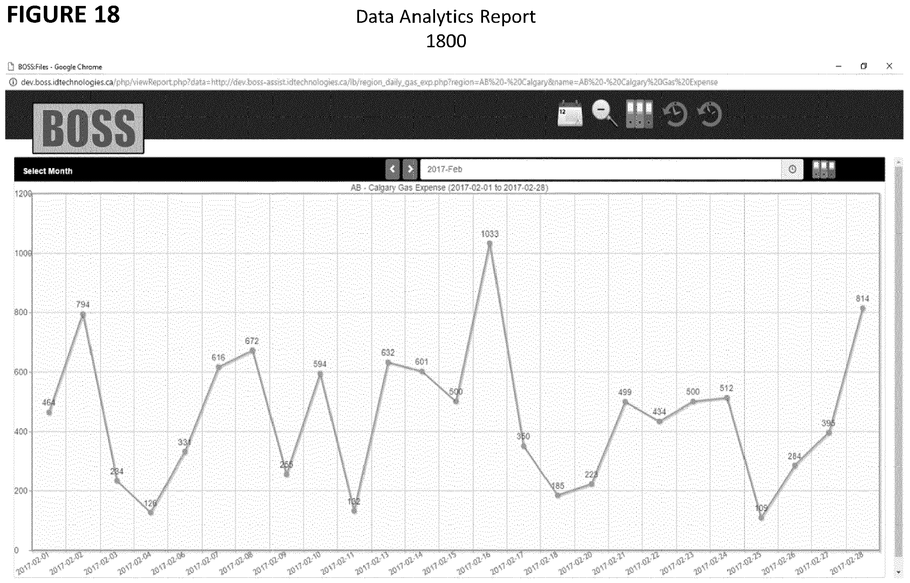

Figure 18 depicts an exemplary data analytics report generated by reporting module 405.

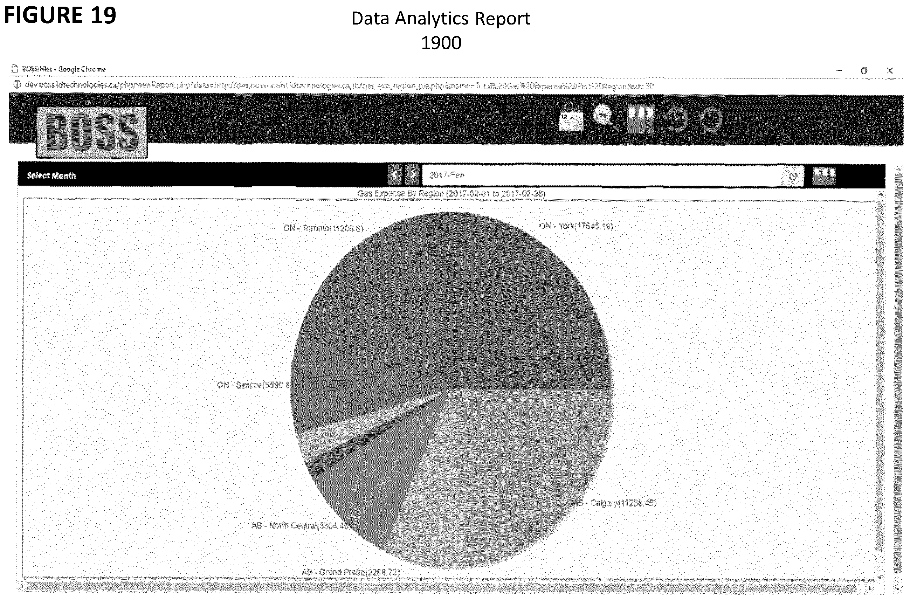

Figure 19 depicts an exemplary data analytics report generated by reporting module 405.

Server 400 optionally can perform additional functions. For example, server 400 can maintain servicing and maintenance records for particular structures (e.g., fire hydrants, insulators, etc.). As another example, server 400 can automatically generates work orders for dispatching repair crews or emergency responders whenever an alert is generated.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A system for monitoring integrity of a gas pipeline, comprising:
a plurality of pressure sensors installed along the gas pipeline, wherein each pressure sensor measures a gas pressure in the pipeline and outputs pressure data; and
a computing device for generating a location image for the gas pipeline and superimposing a graphical alert indicating a location of an incident where the pressure data output by a sensor is lower than the pressure data output by another sensor by more than a predetermined threshold.

2. The system of claim 1, wherein the location image comprises a photograph, a map, and/or a blueprint.

3. The system of claim 1 or 2, wherein each pressure sensor outputs pressure data over a fiber optic cable.

4. The system of one of claims 1 to 3, further comprising a sensor hub for receiving the pressure data over the fiber optic cable.

5. The system of one of claims 1 to 4, further comprising a client device for generating an alert indicating the location of the incident.

6. A system for monitoring integrity of an electric line, comprising:
an induction based leakage detector installed between an electric medium and ground and configured to sense ground leakage current from the electricity medium and to output data indicating the presence of the ground leakage current; and
a computing device for generating a location image for the electric line and superimposing a graphical alert indicating a location of the ground leakage current.

7. The system of claim 6, wherein the location image comprises a photograph, a map, and/or a blueprint.

8. The system of claim 6 or 7, wherein the induction based leakage detector comprises:
an inductor for receiving some or all of the ground leakage current;
an amplifier for amplifying a signal received from the inductor;
a current sensor for measuring a current received from the amplifier;
a processor for generating data in response to the measured current from the current sensor; and
a wireless transceiver for transmitting the data.

9. The system of claim 8, further comprising a sensor hub for receiving the data.

10. The system of one of claims 6 to 9, further comprising a client device for generating an alert indicating the location of the ground leakage current.

11. A system for monitoring integrity of a gas pipeline and an electric network, comprising:
a gas sensor sub-system, comprising:
an induction based leakage detector installed between an electric medium and ground and configured to sense ground leakage current from the electricity medium and to output data indicating the presence of the ground leakage current; and
an electricity network sensor sub-system, comprising:
an induction based leakage detector installed between an electric medium and ground and configured to sense ground leakage current from the electricity medium and to output data indicating the presence of the ground leakage current; and
a computing device for generating a location image for the gas pipeline and the electric medium and superimposing a graphical alert indicating a location of an incident where the pressure data output by a sensor is lower than the pressure data output by another sensor by more than a predetermined threshold and a graphical alert indicating a location of the ground leakage current.

12. The system of claim 11, wherein the location image comprises a photograph, a map, and/or a blueprint.

13. The system of claim 11 or 12, wherein the induction based leakage detector comprises:
an inductor for receiving some or all of the ground leakage current;
an amplifier for amplifying a signal received from the inductor;
a current sensor for measuring a current received from the amplifier;
a processor for generating data in response to the measured current from the current sensor; and
a wireless transceiver for transmitting the data.

14. The system of claim 13 wherein the wireless transceiver transmits the data over a cellular network.
